# EUROPÄISCHE PATENTSCHRIFT

(11) **EP 0 927 455 B1**
(45) Veröffentlichungstag und Bekanntmachung des Hinweises auf die Patenterteilung: **25.07.2001**
(21) Anmeldenummer: 97941841.5
(22) Anmeldetag: 28.08.1997
(51) Int. Cl.: H03H 9/64, H03H 9/145

(54) **REAKTANZFILTER MIT OFW-RESONATOREN**
REACTANCE FILTER WITH SURFACE WAVE RESONATORS
FILTRE A REACTANCE COMPORTANT DES RESONATEURS A ONDE DE SURFACE

(30) Priorität: 19.09.1996 DE 19638451
(43) Veröffentlichungstag der Anmeldung: 07.07.1999
(73) Patentinhaber: EPCOS AG, 81541 München (DE)
(72) Erfinder: MÜLLER, Peter, D-82049 Pullach (DE); PITSCHI, Maximilian, D-83700 Rottach-Egern (DE)
(74) Vertreter: Epping, Wilhelm, Dipl.-Ing.
(86) Internationale Anmeldenummer: DE9701875
(87) Internationale Veröffentlichungsnummer: WO9812806

(56) Entgegenhaltungen:
- EP-A- 0 481 733
- EP-A- 0 652 637
- EP-A- 0 663 721
- GB-A- 2 286 304
- US-A- 4 146 808

## Beschreibung

Die Erfindung betrifft ein Reaktanzfilter, welches aus Oberflächenwellenresonatoren aufgebaut ist. Solche Reaktanzfilter sind beispielsweise aus GB 2 286 304 A oder aus EP 0 663 721 A1 bekannt. Diese Filter bestehen aus mehreren seriell verschalteten Oberflächenwellenresonatoren, wobei zu jedem seriellen Resonator ein weiterer Oberflächenwellenresonator parallel als Ableiter zur Masse hin geschaltet ist. Ein solcher Reaktanzfilter stellt einen Bandpassfilter dar, wenn die Resonanzfrequenzen der Resonatoren so gewählt sind, daß die Resonanzfrequenz eines parallelen Resonators im Bereich der Antiresonanzfrequenz des entsprechenden seriellen Resonators liegt. Es ist bekannt, derartige Filter für breitbandige Systeme, insbesondere als Filter in Abzweigschaltung (Ladder-Type) zu verwenden. Zur Erzielung schmalbandiger Filter wurden Versuche unternommen, bei denen andere Elektrodenmaterialien als Aluminium verwendet und die Metallisierungshöhen verringert wurden. Auch die Variation der Substratmaterialien wurden in die Versuche einbezogen.

Aufgabe der Erfindung ist es, ein Reaktanzfilter der eingangs genannten Art zu schaffen, das als ein schmalbandiges Filter, insbesondere in Abzweigschaltung (Ladder-Type) ausgebildet ist.

Diese Aufgabe wird erfindungsgemäß durch ein Reaktanzfilter mit den Merkmalen von Patentanspruch 1 gelöst.

Aus der EP 0 481 733 A1 ist es bekannt, einen Interdigitalwandler mittels Überlappwichtung zu wichten. Aus der US 4,146,808 ist es bekannt, einen Interdigitalwandler mittels Weglasswichtung zu wichten.

Der jeweilige Resonator wird insbesondere als Eintorresonator ausgebildet, wobei durch die Anordnung und Anzahl der aktiven Finger des Interdigitalwandlers das Kapazitätsverhältnis (statischer zu dynamischer Kapazität) so bemessen ist, daß eine schmale Filterbandbreite erzielt wird. Ferner kann durch die Fingeranordnung des Interdigitalwandlers eines jeden Resonators ein verbessertes Sperrbereichsniveau erreicht werden.

Bei der Ausbildung des Reaktanzfilters als Filter in Abzweigschaltung (Ladder-Type) lassen sich niedrige Einfügedämpfungen erzielen, da keine Leistung über akustische Wegstreckenübertragen wird. Als Elektrodenmaterial kann Al oder eine Al-Legierung, beispielsweise AlCu-Legierung zum Einsatz kommen. Ein geeignetes Substratmaterial ist LiTaO₃ (36°rotYX) oder LiTaO₃ (X112.2°Y). Auch andere herkömmliche piezoelektrische Substratmaterialien beispielsweise LiNbO₃, welches z.B. den Schnitt (64°rotYX) oder (YZ) aufweist, können eingesetzt werden. Die relative Metallisierungshöhe (Metallisierungshöhe/Wellenlänge bei der Mittenfrequenz) der Elektroden beträgt bevorzugt etwa 0,05 bis 0,1 insbesondere 0,07 oder 0,09. Man erreicht bei einem Filter in Abzweigschaltung eine relative 3-dB-Bandbreite von 1.6%. Hieraus resultiert ein vorteilhafter Einsatz bei Duplexern, insbesondere Schnurlostelefon-Duplexern. Die erreichte minimale Einfügedämpfung liegt bei etwa 2.5dB.

Das Verhältnis von statischer zu dynamischer Kapazität der für das Filter verwendeten Eintorresonatoren kann durch Verwendung von weglaßgewichteten Normalfingerwandlern so variiert werden, daß deutlich schmalbandigere Filter in Abzweigschaltung als bisher erreicht werden können.

In den Figuren wird anhand von Ausführungsbeispielen die Erfindung noch näher erläutert. Es zeigt
- Figur 1: das Elektrodenlayout eines Resonators mit weglaßgewichtetem Normalfingerwandler, welcher beim Ausführungsbeispiel der Erfindung zum Einsatz kommt;
- Figur 2: ein Schaltbild eines Reaktanzfilters in Abzweigschaltung (Ladder-Type), welches ein Ausführungsbeispiel der Erfindung ist;
- Figur 3: eine Übertragungsfunktion des Ausführungsbeispiels der Figuren 1 und 2;
- Figur 4: ein weiteres Ausführungsbeispiel der Erfindung;
- Figur 5: Übertragungsfunktionen eines herkömmlichen Filters und des Ausführungsbeispiels der Figur 4; und
- Figur 6: eine Filterstruktur eines Interdigitalwandlers, der beim Ausführungsbeispiel der Figur 4 bei einem gewichteten Resonator verwendet wird.

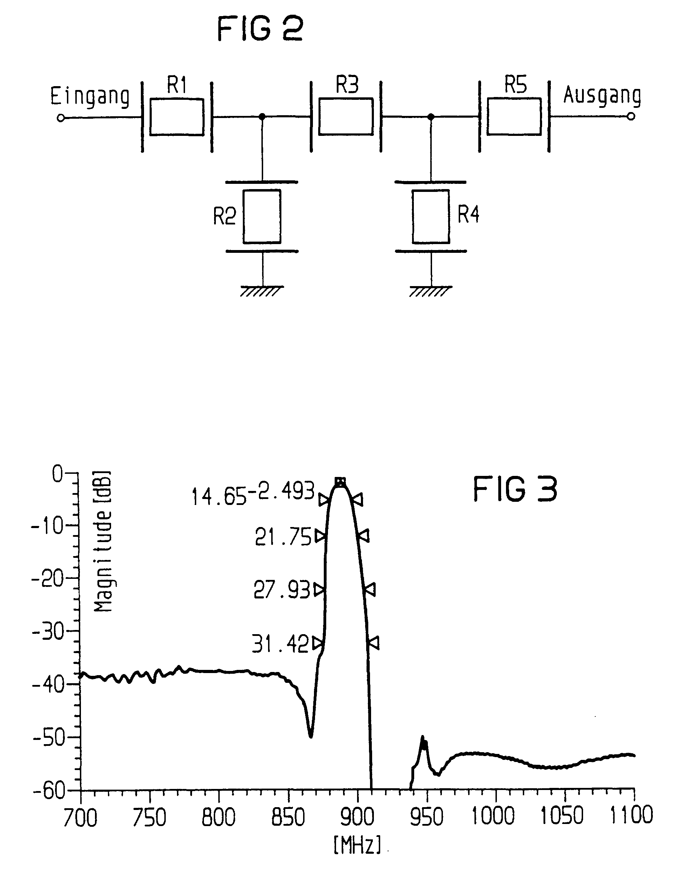

Wie das Ausführungsbeispiel der Fig. 2 zeigt, sind fünf Eintorresonatoren R1 bis R5 in einer Abzweigschaltung miteinander verbunden. Drei Resonatoren R1, R3, R5 sind in Serie zum Signalweg vom Eingang zum Ausgang geschaltet. Zwei Resonatoren R2, R4 sind parallelgeschaltet und liegen zwischen der Serienschaltung und Masse. Die Anschlüsse der beiden Parallelresonatoren R2, R4 liegen jeweils zwischen einem der beiden äußeren Serienresonatoren Rl, R5 und dem mittleren Serienresonator R3. Die Serienresonatoren R1, R3 und R5 besitzen gleiche Kapazitätsverhältnisse. Die beiden Parallelresonatoren R2, R4 besitzen ein größeres Kapazitätsverhältnis als die Serienresonatoren. Die jeweiligen Kapazitätsverhältnisse lassen sich durch geeignete Wichtung erreichen.

Durch entsprechende Anzahl der aktiven Gruppen, deren Anordnung sowie der Fingerzahl im Hinblick auf eine gewünschte Übertragungsfunktion erreicht man eine verbesserte Selektion des Reaktanzfilters gegenüber herkömmlichen Filtern in Abzweigschaltung. Die Übertragungsfunktion ist in Fig. 3 dargestellt. Das Filter ist an 50Ω selbst angepaßt. Die Einfügedämpfung beträgt ca. 2,5 dB. Die relative 3-dB-Bandbreite beträgt ca. 1.6%. Die relative Metallisierungshöhe beträgt 0,09.

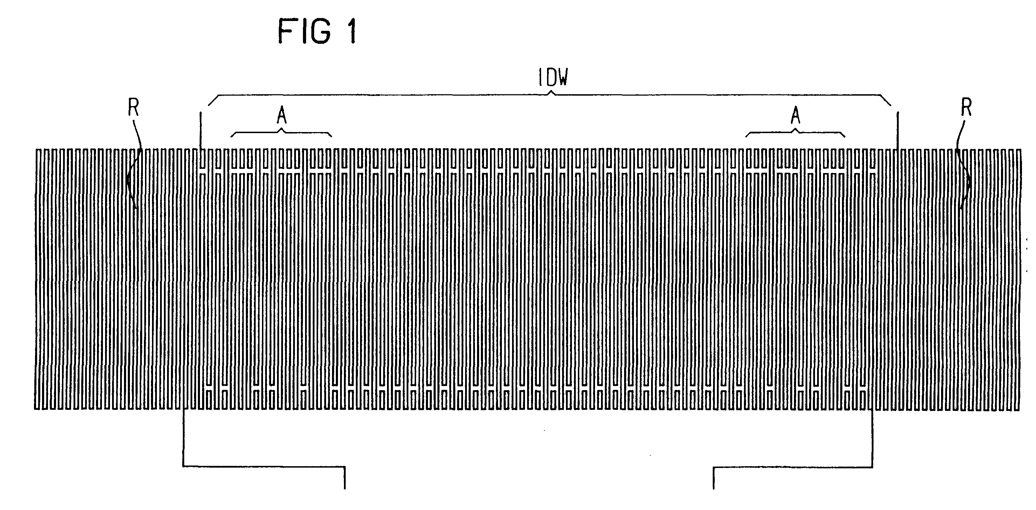

Zur Erläuterung ist in Fig. 1 ein Eintorresonator dargestellt, welcher stellvertretend für die verwendeten Eintorresonatoren R1 - R5 (Figur 2) zur Erläuterung der Weglaßwichtung gezeigt ist. Aus der Fig. 1 ist zu ersehen, daß beim Interdigitalwandler IDW die Weglaßwichtung insbesondere im Bereich der beiden äußeren Abschnitte A des Interdigitalwandlers IDW vorgesehen ist. Im zentralen Bereich dazwischen besitzt der Interdigitalwandler eine uniforme Struktur. Zur Vervollständigung des Eintorresonators sind Endreflektoren R vorgesehen.

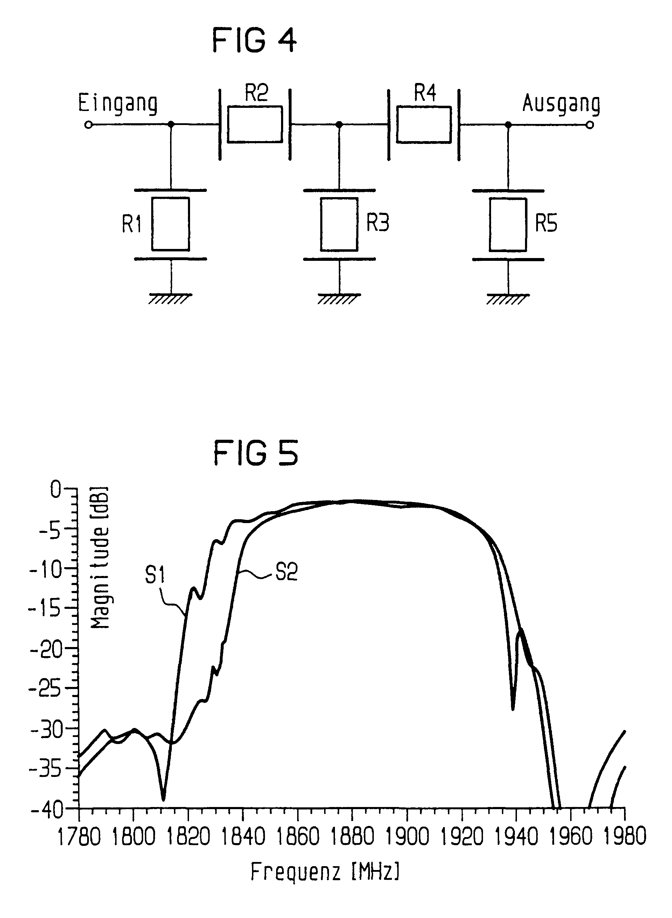

Bei dem in Fig. 4 dargestellten Ausführungsbeispiel sind zwei Serienresonatoren R2, R4, welche in Serie zum Signalweg vom Eingang zum Ausgang geschaltet sind, vorgesehen. Ferner sind drei Parallelresonatoren R1, R3, R5 vorgesehen. Die eine Seite des Resonators R1 ist zwischen dem Eingang und dem ersten Serienresonator 2 angeschlossen. Der zweite Parallelresonator ist zwischen den beiden Serienresonatoren angeschlossen und der dritte Parallelresonator R5 ist zwischen dem Ausgang und dem zweiten Serienresonator R4 angeschlossen. Die anderen Seiten der Parallelresonatoren sind mit Massepotential verbunden.

Bei dieser Ausführungsform des Filters in Abzweigschaltung sind die Parallelresonatoren R1, R3 und R5 ungewichtet. Die Wandler dieser Resonatoren sind uniforme Wandler. Die Wandler der Serienresonatoren R2 und R4 sind gewichtet. Sie besitzen gleiche Wichtung. Bei den Parallelresonatoren kann der mittlere Parallelresonator R3 eine geringere Fingeranzahl aufweisen als die beiden äußeren Parallelresonatoren R1 und R5.

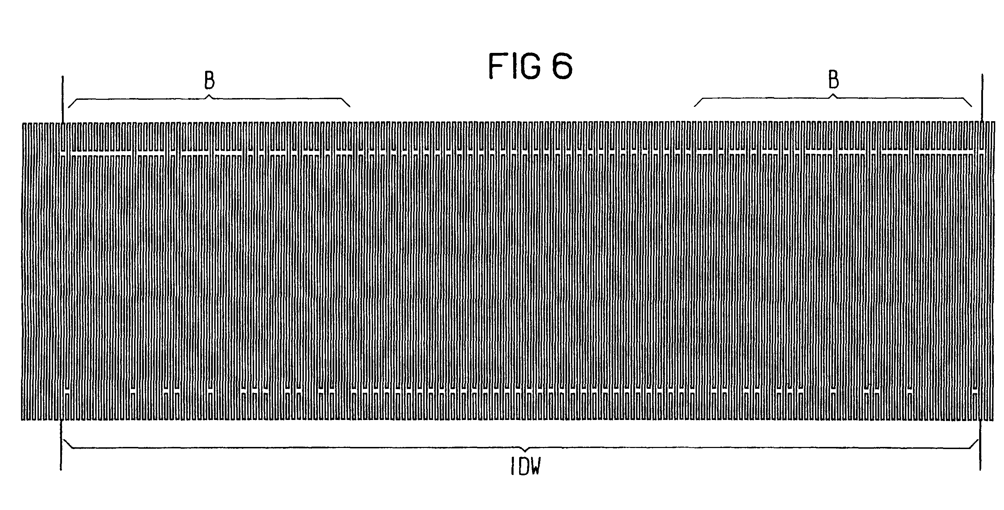

In der Fig. 6 ist die Fingerstruktur eines Ausführungsbeispiels für einen weglaßgewichteten Interdigitalwandler IDW gezeigt, welcher bei den gewichteten Resonatoren R2 und R4 der Fig. 4 verwendet werden kann. Wie aus der Figur 6 zu ersehen ist, befinden sich in den äußeren Endbereichen des Interdigitalwandlers Abschnitte mit relativ hoher Weglaßwichtung, die in Richtung zur Mitte des Wandlers hin sich allmählich verringert. Die Abschnitte B mit den Weglaßrichtungen sind länger bemessen als beim Ausführungsbeispiel der Fig. 1. Im zentralen Bereich des Wandlers besitzt dieser eine Normalfingerstruktur.

In der Fig. 5 ist die Übertragungsfunktion S1 eines herkömmlichen Filters und die Übertragungsfunktion S2 des in Fig. 4 dargestellten Ausführungsbeispiels mit einer relativen Metallisierungshöhe von 0,07 gezeigt. Daraus ergibt sich, daß beim Filter gemäß der Erfindung eine verbesserte Flankensteilheit im rechten Übergangsbereich und eine Verringerung der Bandbreite erzielt wird.

## Patentansprüche

1. Reaktanzfilter mit OFW-Resonatoren (R1 - R5), bei denen zwischen Reflektoren Interdigitalwandler (IDW) angeordnet sind,
bei dem der Interdigitalwandler wenigstens einer der Resonatoren als weglaßgewichteter Normalfingerwandler (IDW) ausgebildet ist.

2. Reaktanzfilter nach Anspruch 1,
bei dem die Anordnung und Anzahl der aktiven Finger des Interdigitalwandlers (IDW) zur Änderung des Kapazitätsverhältnisses (statischer zu dynamischer Kapazität) so bemessen sind, daß eine schmale Filterbandbreite erzielt ist.

3. Reaktanzfilter nach Anspruch 1 oder 2,
bei dem die Weglaßwichtung in den beiden Endabschnitten (A; B) des Interdigitalwandlers (IDW) vorgesehen ist.

4. Reaktanzfilter nach einem der Ansprüche 1 bis 3,
bei dem mehrere Resonatoren (R1 - R5) in Abzweigschaltung (Ladder-Type) miteinander verbunden sind, wobei wenigstens einer der Resonatoren einen gewichteten Wandler aufweist.

5. Reaktanzfilter nach Anspruch 4,
bei dem drei Resonatoren (R1, R3, R5) in Serie und zwei Resonatoren (R2, R4) parallel zueinander geschaltet sind.

6. Reaktanzfilter nach Anspruch 5,
bei dem die beiden äußeren Serienresonatoren (R1, R5) eine gleich große Wichtung haben.

7. Reaktanzfilter nach Anspruch 5 oder 6,
bei dem der mittlere Resonator (R3) der Serienschaltung die gleiche Wichtung wie die beiden äußeren Resonatoren (R1, R5) der Serienschaltung, jedoch eine geringere Fingeranzahl als diese Resonatoren hat.

8. Reaktanzfilter nach einem der Ansprüche 5 bis 7,
bei dem die beiden Parallelresonatoren (R2, R5) eine gleich große Wichtung haben.

9. Reaktanzfilter nach einem der Ansprüche 5 bis 8,
bei dem die Parallelresonatoren (R2, R5) stärker gewichtet sind als die Serienresonatoren (R1, R3, R5)

10. Reaktanzfilter nach Anspruch 4,
bei dem zwei Resonatoren (R2, R4) in Serie und drei Resonatoren (R1, R3, R5) parallel zueinander geschaltet sind.

11. Reaktanzfilter nach Anspruch 10,
bei dem nur die Serienresonatoren (R2, R4) gewichtete Wandler (IDW) aufweisen.

12. Reaktanzfilter nach Anspruch 10 oder 11,
bei dem der jeweilige Wandler (IDW) in den Endabschnitten (B) eine von außen nach innen abnehmende Wichtung aufweist.

13. Reaktanzfilter nach einem der Ansprüche 1 bis 12,
bei dem das Elektodenmaterial der Resonatoren Al oder eine Al-Legierung ist.

14. Reaktanzfilter nach Anspruch 13,
bei dem die relative Metallisierungshöhe etwa 0,05 bis 0,1 beträgt.

15. Reaktanzfilter nach einem der Ansprüche 1 bis 14,
bei dem das Substratmaterial der Resonatoren LiTaO₃, insbesondere mit einem Schnitt (36°rot XY) oder (X112.2°Y) ist.

16. Reaktanzfilter nach einem der Ansprüche 1 bis 14,
bei dem das Substratmaterial der Resonatoren LiNbO₃, insbesondere mit einem Schnitt (64° rotXY) oder (YZ) ist.

17. Reaktanzfilter nach einem der Ansprüche 1 bis 16,
bei dem die Resonatoren (R1 - R5) als Eintorresonatoren ausgebildet sind.

18. Reaktanzfilter nach einem der Ansprüche 1 bis 18,
das als CT1+ Tx-Filter ausgebildet ist.

19. Reaktanzfilter nach einem der Ansprüche 1 bis 18, gekennzeichnet durch seine Verwendung in einem Duplexer.

## Claims

1. Reactance filter with SAW resonators (R1 - R5) in which interdigital transducers (IDW) are arranged between reflectors, and
in which the interdigital transducer of at least one of the resonators is in the form of an omission-weighted normal finger transducer (IDW).

2. Reactance filter according to Claim 1,
in which the arrangement and number of active fingers in the interdigital transducer (IDW) are dimensioned in order to vary the capacitance ratio (steady-state to dynamic capacitance) such that a narrow filter bandwidth is achieved.

3. Reactance filter according to Claim 1 or 2,
in which the omission weighting is provided in the two end sections (A; B) of the interdigital transducer (IDW).

4. Reactance filter according to one of Claims 1 to 3,
in which a number of resonators (R1 - R5) are connected to one another in a branch circuit (ladder type), with at least one of the resonators having a weighted transducer.

5. Reactance filter according to Claim 4,
in which three resonators (R1, R3, R5) are connected in series, and two resonators (R2, R4) are connected in parallel with one another.

6. Reactance filter according to Claim 5,
in which the two outer series resonators (R1, R5) have the same weighting.

7. Reactance filter according to Claim 5 or 6,
in which the central resonator (R3) in the series circuit has the same weighting as the two outer resonators (R1, R5) in the series circuit, but has a smaller number of fingers than these resonators.

8. Reactance filter according to one of Claims 5 to 7,
in which the two parallel resonators (R2, R5) have the same weighting.

9. Reactance filter according to one of Claims 5 to 8,
in which the parallel resonators (R2, R5) are more heavily weighted than the series resonators (R1, R3, R5).

10. Reactance filter according to Claim 4,
in which two resonators (R2, R4) are connected in series and three resonators (R1, R3, R5) are connected in parallel with one another.

11. Reactance filter according to Claim 10,
in which only the series resonators (R2, R4) have weighted transducers (IDW).

12. Reactance filter according to Claim 10 or 11,
in which the respective transducer (IDW) has a weighting which decreases from the outside inwards in the end sections (B).

13. Reactance filter according to one of Claims 1 to 12,
in which the electrode material of the resonators is aluminium or an aluminium alloy.

14. Reactance filter according to Claim 13,
in which the relative metallization height is approximately 0.05 to 0.1.

15. Reactance filter according to one of Claims 1 to 14,
in which the substrate material of the resonators is LiTaO₃, in particular with a cut (36°red XY) or (X112.2°Y).

16. Reactance filter according to one of Claims 1 to 14,
in which the substrate material of the resonators is LiNbO₃, in particular with a cut (64°redXY) or (YZ).

17. Reactance filter according to one of Claims 1 to 16,
in which the resonators (R1 - R5) are in the form of single-port resonators.

18. Reactance filter according to one of Claims 1 to 18,
which is in the form of a CT1+ Tx filter.

19. Reactance filter according to one of Claims 1 to 18,
characterized by its use in a duplexer.

## Revendications

1. Filtre à réactance ayant des résonateurs à ondes de surface (R1 à R5), dans lesquels des transducteurs interdigités (IDW) sont disposés entre des réflecteurs,
dans lequel le transducteur interdigité au moins de l'un des résonateurs est conçu comme un transducteur digité normal (IDW) pondéré par omission.

2. Filtre à réactance selon la revendication 1,
dans lequel la disposition et le nombre des doigts actifs du transducteur interdigité (IDW) sont dimensionnés pour la modification du rapport de capacités (capacité statique à capacité dynamique) de manière à obtenir une largeur de bande de filtre étroite.

3. Filtre à réactance selon la revendication 1 ou 2,
dans lequel la pondération par omission est prévue dans les deux tronçons terminaux (A ; B) du transducteur interdigité (IDW).

4. Filtre à réactance selon l'une des revendications 1 à 3,
dans lequel plusieurs résonateurs (R1 à R5) sont reliés en circuit de dérivation (type en échelle), au moins l'un des résonateurs comportant un transducteur pondéré.

5. Filtre à réactance selon la revendication 4,
dans lequel trois résonateurs (R1, R3, R5) sont branchés en série et deux résonateurs (R2, R4) sont branchés en parallèle.

6. Filtre à réactance selon la revendication 5,
dans lequel les deux résonateurs série extérieurs (R1, R5) ont une pondération identique.

7. Filtre à réactance selon la revendication 5 ou 6,
caractérisé par le fait que le résonateur central (R3) du circuit série a la même pondération que les deux résonateurs extérieurs (R1, R5) du circuit série mais a un plus petit nombre de doigts que ces résonateurs.

8. Filtre à réactance selon l'une des revendications 5 à 7,
dans lequel les deux résonateurs parallèles (R2, R5) ont une pondération identique.

9. Filtre à réactance selon l'une des revendications 5 à 8,
dans lequel les résonateurs parallèles (R2, R5) ont une pondération plus grande que les résonateurs série (R1, R3, R5).

10. Filtre à réactance selon la revendication 4,
dans lequel deux résonateurs (R2, R4) sont branchés en série et trois résonateurs (R1, R3, R5) sont branchés en parallèle.

11. Filtre à réactance selon la revendication 10,
dans lequel seuls les résonateurs série (R2, R4) comportent des transducteurs (IDW) pondérés.

12. Filtre à réactance selon la revendication 10 ou 11,
dans lequel le transducteur (IDW) respectif comporte dans les tronçons terminaux (B) une pondération diminuant de l'extérieur vers l'intérieur.

13. Filtre à réactance selon l'une des revendications 1 à 12,
dans lequel le matériau d'électrode des résonateurs est de l'aluminium Al ou un alliage d'aluminium Al.

14. Filtre à réactance selon la revendication 13,
dans lequel la hauteur de métallisation relative vaut environ 0,05 à 0,1.

15. Filtre à réactance selon l'une des revendications 1 à 14,
dans lequel le matériau de substrat des résonateurs est LiTaO₃, notamment avec une coupe (36°rotXY) ou (X112.2°Y).

16. Filtre à réactance selon l'une des revendications 1 à 14,
dans lequel le matériau de substrat des résonateurs est LiNbO₃, notamment avec une coupe (64°rotXY) ou (YZ).

17. Filtre à réactance selon l'une des revendications 1 à 16,
dans lequel les résonateurs (R1 à R5) sont conçus comme des résonateurs à une porte.

18. Filtre à réactance selon l'une des revendications 1 à 18,
qui est conçu comme filtre CT1+ Tx.

19. Filtre à réactance selon l'une des revendications 1 à 18,
caractérisé par son utilisation dans un duplexeur.
